# EUROPEAN PATENT APPLICATION

(11) **EP 2 482 304 A1**
(43) Date of publication of application: **01.08.2012**
(21) Application number: 12150890.7
(22) Date of filing: 12.01.2012
(51) Int. Cl.: H01J 37/32

(54) **Plasma Reaction Method and Plasma Reaction Device**

(30) Priority: 26.01.2011 TW 100102842
(71) Applicant: Lai, Ping-Li, Woo-Jih Taichung City T'ai pei (TW)
(72) Inventor: Lai, Ping-Li, Woo-Jih Taichung City T'ai pei (TW)
(74) Representative: ip21 Ltd

(57) **Abstract**

A plasma reaction method and a plasma reaction device. The plasma reaction method includes steps of: installing at least one conductive coil set in a closed space; filling a reaction fluid into the closed space; and applying an electric field and/or a magnetic field to the conductive coil set, whereby the surface particles of the conductive coil in the closed space are ionized by the magnetic field or electric field into high-energy electrons, high-energy ions and high-energy neutral atoms to carry out plasma reaction. By means of the plasma reaction method and device, in the closed space, the transformation between electric energy and electric energy, electric energy and magnetic energy, magnetic energy and magnetic energy and electrons of the materials can be more efficiently performed.

## Description

### BACKGROUND OF THE INVENTION

### FIELD OF THE INVENTION

The present invention relates generally to a plasma reaction method and a plasma reaction device. The plasma reaction method includes steps of: installing at least one conductive coil set in a closed space; filling a reaction fluid into the closed space; and applying an electric field and/or a magnetic field to the conductive coil set to carry out plasma reaction. By means of the plasma reaction method and device, in the closed space, the transformation between electric energy and electric energy, electric energy and magnetic energy, magnetic energy and magnetic energy and electrons of the materials can be more efficiently performed.

### DESCRIPTION OF THE PRIOR ART

A solenoid is formed of a uniformly spiraled elongated conductive wire. According to Ampere's Circuit Law, when the solenoid is powered on, a uniform magnetic field is created in the solenoid. It is known that a solenoid with a soft iron core (magnetic iron material) positioned therein has a magnetic flux much greater than the magnetic flux of a hollow solenoid. However, an eddy current will be produced in the soft iron core (magnetic iron material) to generate heat and cause loss of magnetic energy or interference.

To solve the above problems, the soft iron core (magnetic iron material) can be replaced with thinner multilayer laminated silicon steel sheets to lower the saturation of magnetic path and reduce eddy current. Accordingly, the problems of heat and loss of energy due to the eddy current can be properly solved. However, the eddy current still can be hardly thoroughly eliminated so that the problems of heat and the resultant loss of energy still exist. This is because air is a medium with very high magnetic resistance. Therefore, the magnetic flux inside the solenoid can be hardly increased.

Besides, as long as the magnetic iron material or silicon steel sheets are positioned inside the solenoid, the problem of magnetic force interference always exists between the electromagnetic field and the magnetic iron material or silicon steel sheets and is hard to solve.

Plasma is a material in a plasma state, which is mainly composed of high-energy electrons, high-energy ions and high-energy neutral atoms. Plasma has a very high electrical conductivity. Plasma was discovered by Sir William Crookes in 1879. Plasma is a gas mass with high potential energy and high kinetic energy. Plasma carries such a total charge that it is neutral. The outer layer of electrons are struck out by the high kinetic energy of the electric and/or magnetic field to escape from the confinement of the atomic nucleus and become free electrons with high potential energy and high kinetic energy.

Plasma is widely applied in various fields. For example, plasma is used to manufacture displays. Also, ion deposition technique and coating control technique are used to improve the textures and structures of coatings and expedite chemical reaction processes so as to facilitate formation of compound coatings.

The plasma reaction is generally performed "between two electrode plates". In some cases, plasma is alternatively produced by means of a solenoid. However, up to the present time, in all methods for producing plasma, the produced plasma is "additionally taken out and transferred" for other specified usages rather than kept in the original site in which the plasma is produced. For example, all of the above ion deposition technique, coating control technique, display technique, etc. pertain to such sort of techniques.

As aforesaid, air is a medium with very high magnetic resistance. Therefore, the magnetic flux inside the solenoid can be hardly increased. The soft iron core (magnetic iron material) can be replaced with thinner multilayer laminated silicon steel sheets to lower the saturation of magnetic path and reduce eddy current. In this case, the problems of heat and the resultant loss of energy due to the eddy current can be properly solved. However, this will lead to increase of volume and weight of the device. Moreover, the eddy current still can be hardly thoroughly eliminated. As a result, the transformation between electric energy and electric energy, electric energy and magnetic energy, magnetic energy and magnetic energy and electrons of the materials can be hardly efficiently performed.

In addition, the problem of magnetic force interference between the magnetic field and the magnetic iron material or silicon steel sheets is still hard to solve.

### SUMMARY OF THE INVENTION

It is therefore a primary object of the present invention to provide a plasma reaction method in which at least one conductive coil set is installed in a closed space. A reaction fluid ("fluid" means gas or liquid) is filled in the closed space. An electric field and/or a magnetic field is applied to the conductive coil set, whereby the conductive coil and the reaction fluid in the closed space interact on each other to carry out plasma reaction in the closed space.

It is a further object of the present invention to provide the above plasma reaction method in which one or multiple conductive coil sets are arranged in the closed space. The multiple conductive coil sets are symmetrically arranged.

It is still a further object of the present invention to provide the above plasma reaction method in which the conductive coil set or at least one of the conductive coil sets has at least one terminal extending out of the closed space. Accordingly, the electric field and/or magnetic field can be applied to the conductive coil by way of conduction.

It is still a further object of the present invention to provide the above plasma reaction method in which the conductive coil set or at least one of the conductive coil sets has at least one terminal sealedly enclosed in the closed space without contacting the exterior of the closed space, whereby the magnetic field can be applied to the conductive coil by way of induction.

It is still a further object of the present invention to provide a plasma reaction device including a closed space and at least one conductive coil set installed in the closed space. A reaction fluid is filled in the closed space. An electric field and/or a magnetic field is applied to the conductive coil set, whereby the conductive coil and the reaction fluid in the closed space interact on each other to carry out plasma reaction in the closed space.

The plasma reaction device includes one or multiple conductive coil sets. The multiple conductive coil sets are symmetrically arranged.

In the above plasma reaction device, the conductive coil set or at least one of the conductive coil sets has at least one terminal extending out of the closed space. Accordingly, the electric field and/or magnetic field can be applied to the conductive coil by way of conduction.

In the above plasma reaction device, the conductive coil set or at least one of the conductive coil sets has at least one terminal sealedly enclosed in the closed space without contacting the exterior of the closed space, whereby the magnetic field can be applied to the conductive coil by way of induction.

The present invention can be best understood through the following description and accompanying drawings, wherein:

### BRIEF DESCRIPTION OF THE DRAWINGS

Fig. 1 is a schematic diagram of a first embodiment of the present invention;
Fig. 2 is a schematic diagram of a second embodiment of the present invention;
Fig. 3 is a schematic diagram of a third embodiment of the present invention;
Fig. 4 is a schematic diagram of a fourth embodiment of the present invention;
Fig. 5 is a schematic diagram of a fifth embodiment of the present invention;
Fig. 6 is a schematic diagram of a sixth embodiment of the present invention;
Fig. 7 is a sectional view taken along line 7-7 of Fig. 6;
Fig. 8 is a perspective exploded view of a seventh embodiment of the present invention;
Fig. 9 is a perspective assembled view of the seventh embodiment of the present invention; and
Fig. 10 is a sectional view taken along line 10-10 of Fig. 9.

### DETAILED DESCRIPTION OF THE PREFERRED EMBODIMENTS

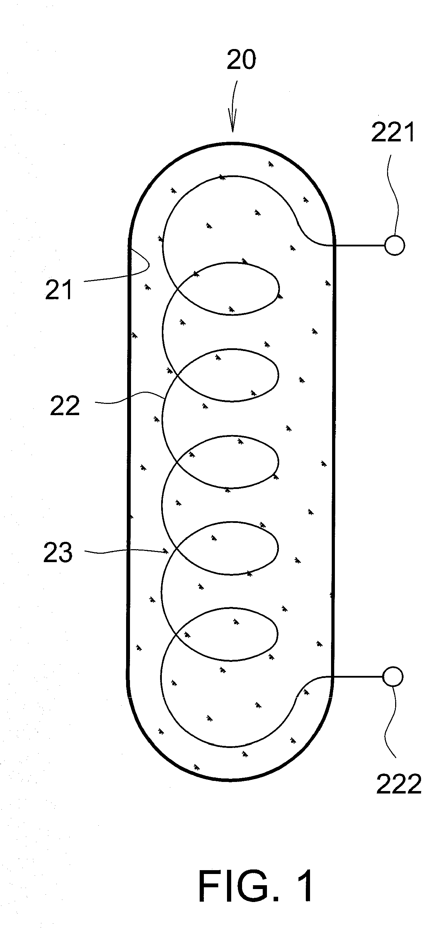

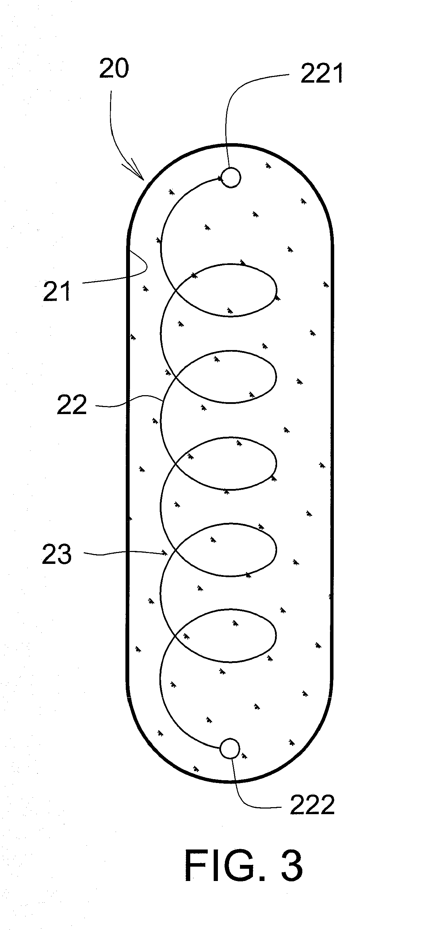

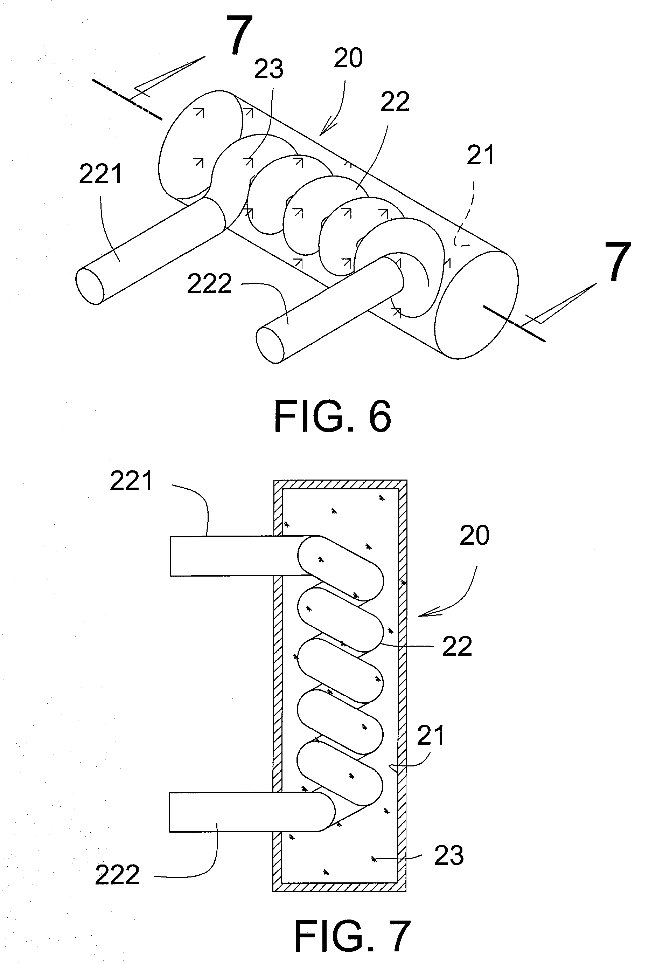

Please refer to Figs. 1 to 10. The present invention relates to a plasma reaction method in which at least one conductive coil set 22 is installed in a closed space 21. A reaction fluid 23 ("fluid" means gas or liquid) is filled in the closed space 21. An electric field and/or a magnetic field is applied to the conductive coil set 22, whereby the surface particles of the conductive coil 22 in the closed space 21 are ionized by the magnetic field or electric field into high-energy electrons, high-energy ions and high-energy neutral atoms. Accordingly, the conductive coil 22 and the reaction fluid 23 in the closed space 21 interact on each other to carry out plasma reaction in the closed space 21. Therefore, in the closed space 21, the transformation between electric energy and electric energy, electric energy and magnetic energy, magnetic energy and magnetic energy and electrons of the materials can be more efficiently performed.

Please further refer to Figs. 1 to 10. In the plasma reaction method of the present invention, one or multiple ("multiple" means two or more) conductive coil sets 22 are arranged in the closed space 21. The multiple conductive coil sets 22 are symmetrically arranged.

Please refer to Figs. 1, 2, 4, 5, 6 and 7. In the plasma reaction method of the present invention, the conductive coil set 22 or at least one of the conductive coil sets 22 has at least one terminal 221 (or 222) extending out of the closed space 21. Accordingly, the terminal 221 can be connected to an external power supply to power on the conductive coil 22 sealedly enclosed in the closed space 21. In this case, the electric field and/or magnetic field can be applied to the conductive coil 22 by way of conduction.

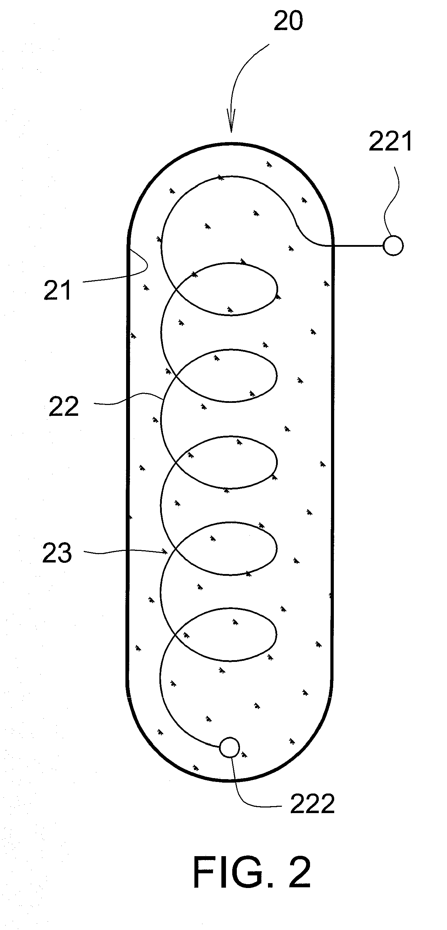

Please refer to Figs. 2, 3, 5, 8, 9 and 10. In the plasma reaction method of the present invention, the conductive coil set 22 or at least one of the conductive coil sets 22 has at least one terminal 222 (or 221) sealedly enclosed in the closed space 21 without contacting the exterior of the closed space 21. In this case, the magnetic field can be applied to the conductive coil 22 by way of induction.

Please refer to Figs. 1 to 10. The present invention also relates to a plasma reaction device 20 including a closed space 21 and at least one conductive coil set 22 installed in the closed space 21. A reaction fluid 23 is filled in the closed space 21. An electric field and/or a magnetic field is applied to the conductive coil set 22, whereby the surface particles of the conductive coil 22 in the closed space 21 are ionized by the magnetic field or electric field into high-energy electrons, high-energy ions and high-energy neutral atoms. Accordingly, the conductive coil 22 and the reaction fluid 23 in the closed space 21 interact on each other to carry out plasma reaction in the closed space 21. Therefore, in the closed space 21, the transformation between electric energy and electric energy, electric energy and magnetic energy, magnetic energy and magnetic energy and electrons of the materials can be more efficiently performed.

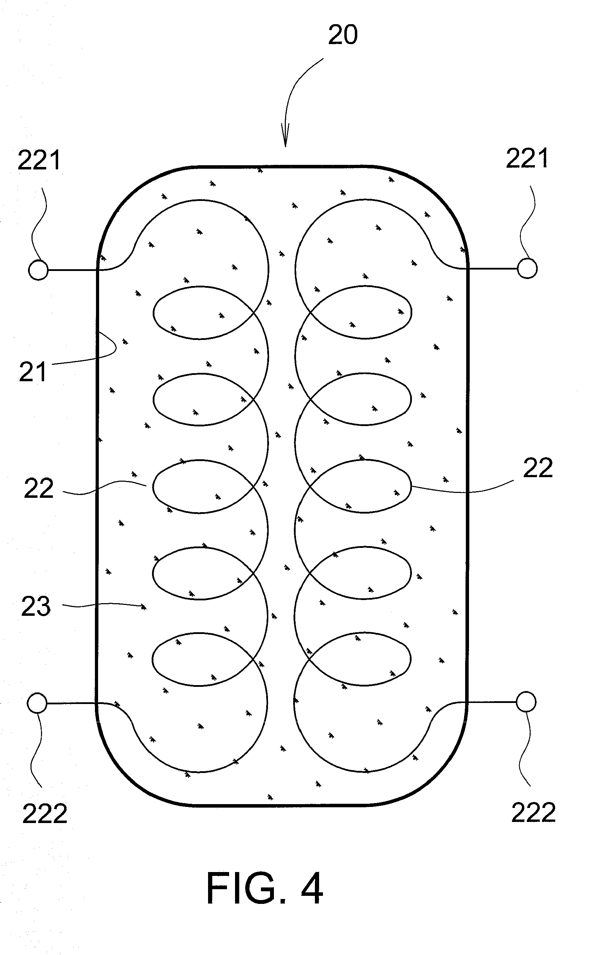

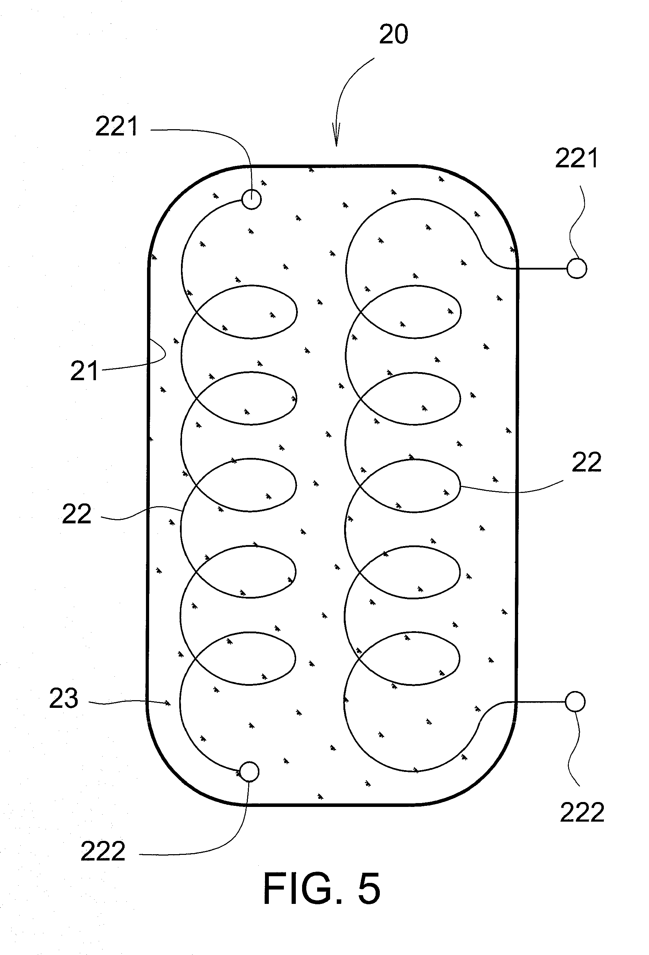

Please further refer to Figs. 1 to 10. In the plasma reaction device 20 of the present invention, one or multiple conductive coil sets 22 are arranged in the closed space 21. As shown in Figs. 4 and 5, the multiple conductive coil sets 22 are symmetrically arranged.

Please refer to Figs. 1, 2, 4, 5, 6 and 7. In the plasma reaction device 20 of the present invention, the conductive coil set 22 or at least one of the conductive coil sets 22 has at least one terminal 221 (or 222) extending out of the closed space 21. In this case, the electric field and/or magnetic field can be applied to the conductive coil 22 by way of conduction.

Please refer to Figs. 2, 3, 5, 8, 9 and 10. In the plasma reaction device 20 of the present invention, the conductive coil set 22 or at least one of the conductive coil sets 22 has at least one terminal 222 (or 221) sealedly enclosed in the closed space 21 without contacting the exterior of the closed space 21. In this case, the magnetic field can be applied to the conductive coil 22 by way of induction.

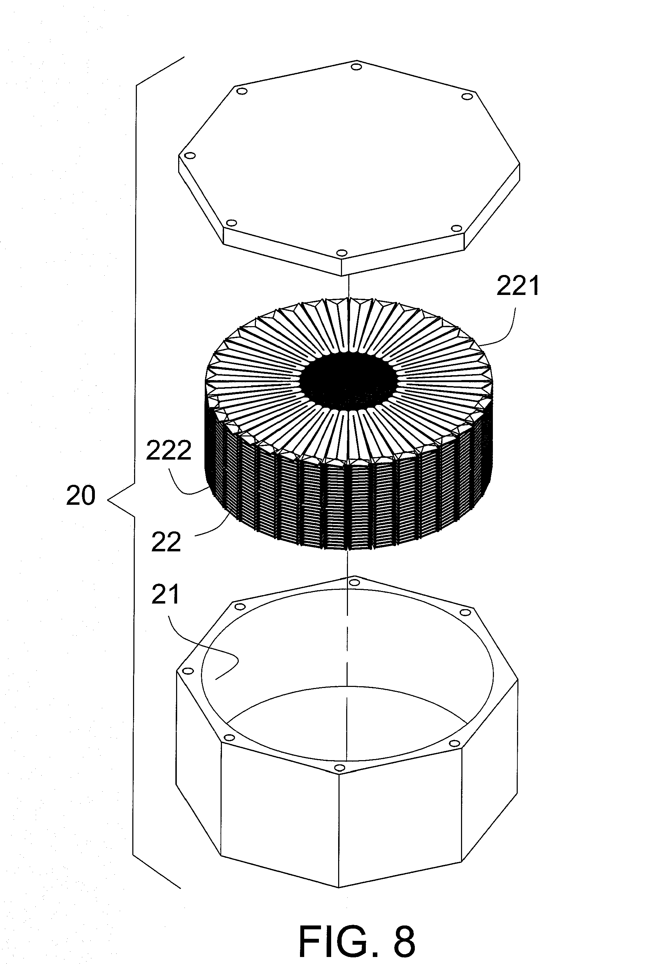

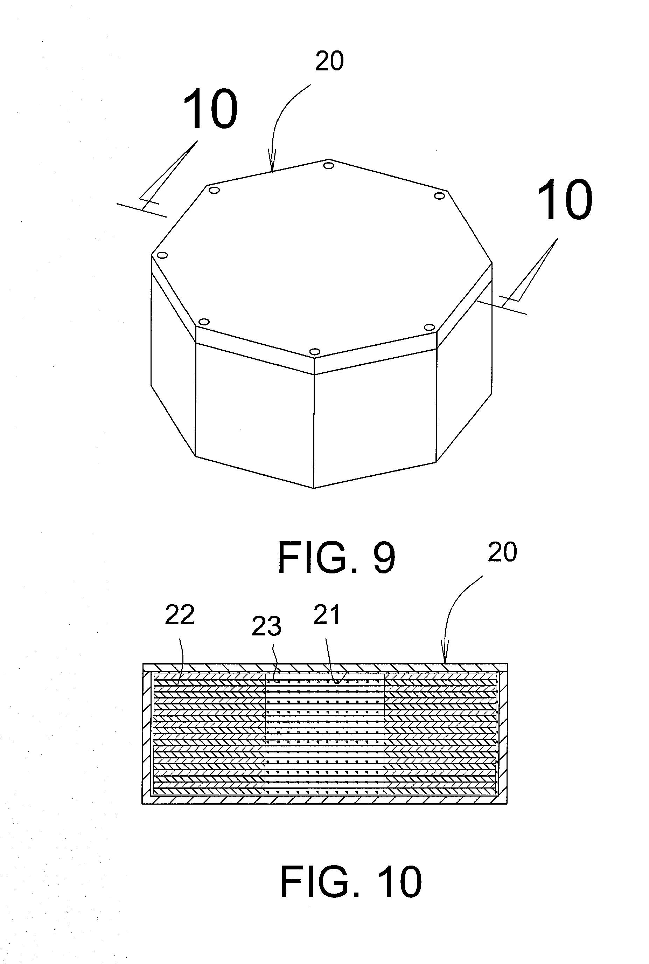

In the plasma reaction device 20 of the present invention, the conductive coil 22 only needs to be partially exposed to contact the reaction fluid 23 for plasma reaction. The exposed parts of the conductive coil 22 are not in contact with each other so as to avoid short-circuit. Accordingly, the conductive coil 22 can be, but not limited to, a bare conductive wire (as shown in Figs. 1 to 7), a stranded wire (not shown) or a conductive plate (with a bare face and an insulation face as shown in Figs. 8 and 10).

According to the above arrangement, the plasma reaction method and plasma reaction device of the present invention have the following advantages:
1. In the plasma reaction method and plasma reaction device of the present invention, at least one conductive coil set 22 is installed in the closed space 21. The reaction fluid 23 is filled in the closed space 21. An electric field and/or a magnetic field is applied to the conductive coil set 22, whereby the particles in the closed space 21 are ionized by the magnetic field or electric field into high-energy electrons, high-energy ions and high-energy neutral atoms to carry out plasma reaction. Therefore, in the closed space 21, the transformation between electric energy and electric energy, electric energy and magnetic energy, magnetic energy and magnetic energy and electrons of the materials can be more efficiently performed.
2. In the plasma reaction method and plasma reaction device of the present invention, the produced plasma is always kept in the closed space 21 for reaction without being "additionally taken out and transferred" for other specified usages. Instead, the plasma is used to enhance the transformation efficiency between electric energy and electric energy, electric energy and magnetic energy, magnetic energy and magnetic energy and electrons of the materials. This is a characteristic of the present invention that is totally different from the conventional technique.
3. In the plasma reaction method and plasma reaction device of the present invention, it is unnecessary to place any magnetic iron material or silicon steel sheet in the conductive coil. Therefore, the present invention is free from the problem of magnetic force interference between the magnetic field and magnetic iron material or silicon steel sheets that exists in the conventional technique.

The above embodiments are only used to illustrate the present invention, not intended to limit the scope thereof. Many modifications of the above embodiments can be made without departing from the spirit of the present invention.

## Claims

1. A plasma reaction method comprising steps of:
(a) installing at least one conductive coil set in a closed space;
(b) filling a reaction fluid into the closed space; and
(c) applying an electric field and/or a magnetic field to the conductive coil set to make the conductive coil set and the reaction fluid in the closed space interact on each other to carry out plasma reaction in the closed space.

2. The plasma reaction method as claimed in claim 1, wherein there is only one conductive coil set.

3. The plasma reaction method as claimed in claim 1, wherein there are multiple conductive coil sets.

4. The plasma reaction method as claimed in claim 3, wherein the multiple conductive coil sets are symmetrically arranged.

5. The plasma reaction method as claimed in claim 1, wherein the conductive coil set or at least one of the conductive coil sets has at least one terminal extending out of the closed space.

6. The plasma reaction method as claimed in claim 1, wherein the conductive coil set or at least one of the conductive coil sets has at least one terminal sealedly enclosed in the closed space without contacting an exterior of the closed space.

7. A plasma reaction device comprising:
(a) a closed space; and
(b) at least one conductive coil set installed in the closed space, a reaction fluid being filled in the closed space, an electric field and/or a magnetic field being applied to the conductive coil set, whereby the conductive coil and the reaction fluid in the closed space interact on each other to carry out plasma reaction in the closed space.

8. The plasma reaction device as claimed in claim 7, wherein the plasma reaction device comprises only one conductive coil set.

9. The plasma reaction device as claimed in claim 7, wherein the plasma reaction device comprises multiple conductive coil sets.

10. The plasma reaction device as claimed in claim 9, wherein the multiple conductive coil sets are symmetrically arranged.

11. The plasma reaction device as claimed in claim 7, wherein the conductive coil set or at least one of the conductive coil sets has at least one terminal extending out of the closed space.

12. The plasma reaction device as claimed in claim 7, wherein the conductive coil set or at least one of the conductive coil sets has at least one terminal sealedly enclosed in the closed space without contacting an exterior of the closed space.
